# EUROPEAN PATENT APPLICATION

(11) **EP 3 671 858 A1**
(43) Date of publication of application: **24.06.2020**
(21) Application number: 18214421.2
(22) Date of filing: 20.12.2018
(51) Int. Cl.: H01L 29/78, H01L 29/423

(54) **LDMOS USING BURIED RAIL AS EXTRA GATE**

(71) Applicant: IMEC vzw, 3001 Leuven (BE)
(72) Inventor: HELLINGS, Geert, 3001 Leuven (BE); CHEN, Shih-Hung, 3001 Leuven (BE); LINTEN, Dimitri, 3001 Leuven (BE)
(74) Representative: AWA Sweden AB

(57) **Abstract**

A field-effect transistor device (100) is disclosed, comprising a source-side region (110) of a first conductivity type and a source (112) of a second conductivity type formed in the source-side region. The device further comprises a drain-side region (120) of the second conductivity type and a drain (122) of the second conductivity type formed in the drain-side region. A gate structure (130) is adapted to control a flow of current through a channel (140) between the source and the drain, and comprises a first gate electrode (132) arranged along and coupled to a first channel portion (142) in the source-side region, and a second gate electrode (134) arranged in a trench (124) in the drain-side region and coupled to a second channel portion (144) in the drain-side region.

## Description

### Technical field

The present inventive concept relates to a field-effect transistor device, and in particular to a laterally diffused metal-oxide-semiconductor field-effect transistor, LDMOSFET, device.

### Background

Laterally diffused metal-oxide-semiconductor, LDMOS, transistor devices are used in applications requiring a relatively high breakdown voltage. These transistor devices are often built on p-type epitaxial substrates, with a p-type channel region formed in a low-doped n-type drain region. The low doping of the n-type drain region results in a relatively large depletion layer with a high blocking voltage, which makes the LDMOS transistor devices attractive in power applications, such as RF power amplifiers in base stations as well as power amplification in broadcast, communication and radar systems.

The low-doped drain region is however a challenge in terms of on-state resistance, since it reduces the drive current of the transistor. The on-state resistance is therefore a prevailing design consideration in order to reduce conduction power losses and improve system efficiency.

### Summary

Although the LDMOS transistor technology provides high power devices exhibiting a relatively high breakdown voltage, the on-state resistance remains a challenge. An object of the present inventive concept is therefore to address this challenge. Additional or alternative objectives may be understood from the following.

According to an aspect of the present inventive concept there is provided a field-effect transistor device comprising:
a source-side region of a first conductivity type and a source of a second conductivity type formed in the source-side region,
a drain-side region of the second conductivity type and a drain of the second conductivity type formed in the drain-side region, and
a gate structure adapted to control a flow of current through a channel between the source and the drain. The gate structure comprises a first gate electrode arranged along and coupled to a first channel portion in the source-side region, and a second gate electrode arranged in a trench in the drain-side region and coupled to a second channel portion in the drain-side region.

The separation between the gate structure and the drain is an important design parameter in prior art LDMOS transistors. The gate structure and the drain are separated from each other by a part of the drain-side region, which may be relatively low doped. The separating distance and the doping of the region between the gate structure and the drain are factors that affect the electric field in the gate dielectric when the transistor is in the off-state. The electric field may be reduced with an increased separation and/or reduced doping, and thereby provide an increased breakdown voltage of the transistor. However, the increased breakdown voltage is also associated with a reduced drive current in the on-state, resulting in conduction power losses. This is due to the increased current path caused by the separation between the gate structure and the drain, and also due to the resistance introduced by the relatively low doping.

The present inventive concept is based on the realisation that by arranging a second gate electrode in a trench in the drain-side region, the on-state resistance may be reduced without compromising the relatively high breakdown voltage. The second gate electrode may be arranged in the drain-side region such that it is coupled to the second channel portion in the drain-side region to enhance the carrier accumulation and thereby lower the resistance.

As mentioned above, the gate structure may be arranged to control a flow of current through the channel extending between the source and the drain. The gate structure may comprise at least two electrodes: a first gate electrode that is coupled to a first channel portion arranged in the source-side region, and a second gate electrode that is coupled to a second channel portion arranged in the drain-side region. The first gate electrode may be coupled to the source-side region through a first dielectric layer, whereas the second gate electrode may be coupled to the drain-side region through a second dielectric layer. The reliability under high-field conditions is an important characteristic of the second dielectric layer, and the second dielectric layer may therefore be relatively thick compared to the first dielectric layer. The first and second dielectric layers may either be formed of the same material, which may be easier to produce, or by different materials. Preferably, the second dielectric layer is made thick enough to withstand the potential difference between the drain and the second gate electrode and thereby provide a drain-to-source breakdown voltage relief, and thin enough to allow a coupling between the second gate electrode and the drain-side region to facilitate conduction in the on-state. The coupling may result in a secondary transistor-like structure improving the operation of the overall transistor device design as long as it conducts more current in the on-state than in the off-state.

The first and second gate electrodes may be functionally separated, such that they can be individually controlled and operated at different voltage levels. In other words, the second gate electrode may be connected to a terminal that is separated from the terminal of the first gate electrode and therefore allows for the second gate electrode to be arranged at a bias voltage that is optimised for the second channel portion and independent from the biasing of the first gate electrode.

Alternatively, the first and second gate electrodes may be electrically connected to each other. By "electrical connection" should be understood as galvanic connection allowing a current path between the electrodes. As a consequence, both gate electrodes may be arranged at the same voltage level and operated by a common terminal. This allows for a more compact device that is easier to route and operate.

The present inventive concept may be implemented in a planar device, in which the source-side region and the drain side region may terminate at approximately the same geometric plane on the surface of the semiconductor device. The transistor device may be built on a substrate in a process including several diffusion or ion implantation steps. The source-side region and the drain side region may be formed as wells in the substrate, defining a p-n junction along the boundary between the wells. Further, the drain may be formed as a well in the drain-side well, and the source as a well in the source-side well. In this layout, the first gate electrode may be arranged above at least the source-side well so as to couple to the first channel portion extending in the source-side well, from the drain towards the drain-side well and the drain. The second gate electrode may be arranged in the trench, which may be arranged at least partly in the drain-side well, to couple to the second channel portion running below the trench, towards the drain. During operation, the first and second gate electrodes may be biased so as to allow a current flow along the first and second channel portions, i.e., from the source, through the source-side well, over the p-n junction, under the trench in the drain-side well, and to the drain.

The present inventive concept may also be implemented in a fin structure, in which first and second semiconductor fins extend in parallel horizontally along the substrate. In this configuration, the trench extends horizontally alongside and between the first and second fins, the source-side region is at least partly arranged in the first fin, a boundary between the source-side region and the drain-side region is arranged in the first fin, and the drain-side region extends from the junction, below the trench and into the second fin.

The source may be arranged in a top portion of the first fin, and the drain portion in a top portion of the second fin. In one example, the top portion of the first fin may comprise a first portion, a second portion and a third portion, all of which being arranged along each other in the length direction of the first fin. In this example, the source may be arranged in the first portion, the source-side region in the second portion, and the drain-side portion at least partly arranged in the third portion. Further, the drain may be arranged in the second fin, abreast of the third region of the first fin.

The fin structure allows for a transistor device in which the first gate electrode is arranged above and along at least a part of the first fin so as to couple to the first channel portion. The first channel portion may extend along the length extension of the first fin, from the source in the source-side region, through the source-side region and into the drain side region of the first fin.

The second gate electrode, which may be formed as a buried rail between the fins, is arranged in the trench extending at least partly into the substrate and the drain-side region. This arrangement allows for the second gate electrode to couple to the second channel portion that extends in the drain-side region, from the first fin, under the trench and towards the drain arranged in the second fin.

The term "conductivity type" refers to the type of dopants, i.e., acceptors (p-type) and donors (n-type). Thus, the first conductivity type may refer to p-type and the second conductivity type to n-type, or vice versa.

The doped regions of the present disclosure, i.e., the source, the source-side region, the drain and the drain side region, may all be formed by addition of dopants such as for example boron and phosphorous. The dopants may be added in various processes utilizing for example diffusion and ion implantation.

The doping can be said to be "low" or "high". Generally, these are relative terms indicating that a low-doped region comprises a lower concentration of dopant atoms than a high-doped region. In some examples, a doping can be said to be low when in the order to one dopant atom is added per 100 million atoms, whereas the doping can be said to be high when in the order of one dopant atom is added per ten thousand atoms.

Each of the first and second gate electrodes may be understood as formed of one or several layers. The layers may be formed of a metal or an electrically conductive semiconductor material, such as highly doped polysilicon. The first gate and the second gate may be similar to each other, or differ in terms of conductivity, structure and material. The gates may be configured to operate on the channel via a dielectric insulator, such as silicon dioxide, and may be arranged to control the current flow in the channel by means of an electric field. The gate structure may also be referred to as being coupled to the channel, which should be understood as arranged in a way that allows the gate electrode to affect the flow in the channel.

The trench, in which the gate electrode may be arranged, may be formed in the drain-side region such that the gate electrode at least partly extends into the region and thereby forces the current to take a longer path as compared to a drain-side region not comprising a trench.

The second gate electrode may be formed as a conductive line arranged in the isolated trench. The conductive line, which also may be referred to as a buried conductive line or rail, may have a length extension in a horizontal direction along the substrate, and may be arranged to couple to the drain-side region of several transistor structures.

Each one of the first and the second fin may be a fin-shaped semiconductor structure extending along and protruding above the substrate, preferably beside each other, in a parallel fashion. The fins may be embedded in an isolation, such as a shallow trench isolation, STI, such that only a top part of the fins protrudes from a surface of the isolation.

As used herein, the term "vertical" denotes a geometrical axis being parallel to a stacking direction of the layers of the device. Correspondingly, a "vertical" axis is perpendicular to a main plane of extension or a main surface of any of the layers of the device. Terms such as "above" and "under" as used herein may accordingly refer to opposite directions along the vertical axis, with respect to a reference. As used herein, the term "horizontal" denotes a horizontal axis being perpendicular to the vertical axis.

The device may include a substrate supporting the afore-mentioned layers of the device. In this case, a "vertical" direction/plane may be understood as a direction/plane being perpendicular to a main plane of extension or main surface of the substrate. Correspondingly a "horizontal" direction/plane may be understood as a direction parallel to a main plane of extension or a main surface of the substrate.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figure 1 is a schematic cross section taken along a channel of a planar transistor device.
Figure 2 is a schematic perspective view of a fin-based transistor device.
Figure 3 is a schematic top view, illustrating the layout of a transistor device comprising a plurality of fins.

### Detailed description

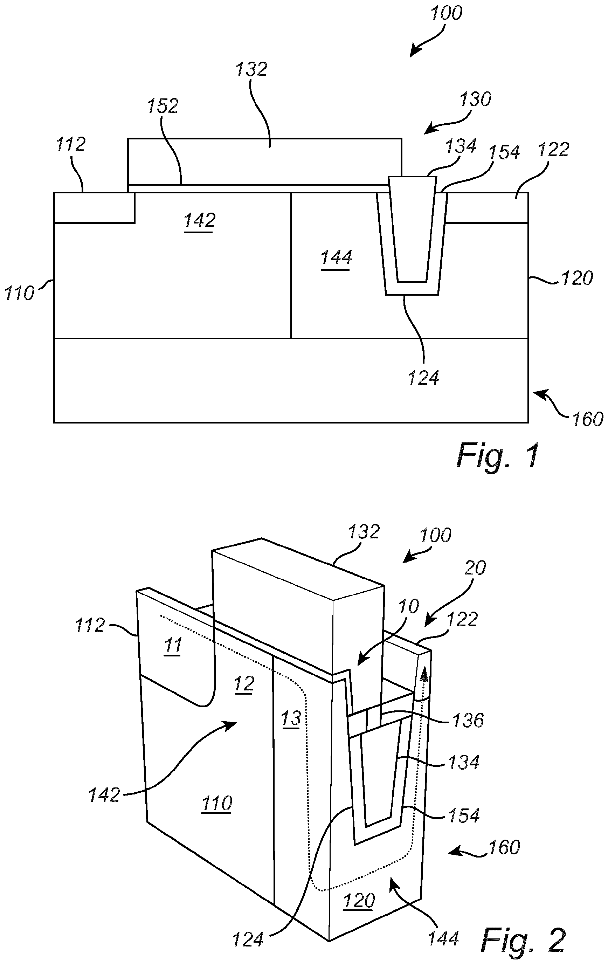

Figure 1 is a cross section of a field-effect transistor device 100 according to an embodiment. The transistor device 100 is formed on a substrate 160, such as for example a p-type epitaxial substrate, in which the source side region 110 and the drain-side region 120 are formed. In the present example, the source-side region 110 and the drain-side region 120 may be formed as ion implanted or diffusion implanted wells arranged in an abutting fashion in the substrate 160. The source-side region 110 may for example be formed as a p-type well 110 in the drain-side region 120, which may be a low-doped n-type well 120. The transistor device according to the present embodiment may be formed as a laterally diffused MOS transistor 100.

A source 112 may be formed in the source-side region 110, and a drain 122 in the drain-side region 120. The source 112 and drain 122 may be provided in the form of highly doped regions in the source-side well 110 and the drain-side well 120, respectively. In the present example, the source 112 and drain 122 may be highly doped n-type regions providing contact regions for the respective terminals of the resulting transistor device.

The source 112 and the drain 122 may be arranged at a lateral distance from each other, along the surface of the substrate, to allow a channel to be formed between them. The channel may hence comprise two different parts: a first channel portion 142 extending through the source-side region 110, and a second channel portion 144 extending through the drain-side region 120.

The channel 142, 144 may be defined by the arrangement of the gate structure 132, 134, which may be provided along and coupled to the channel 142, 144 so as to allow a current flow between the source 112 and the drain 122 to be controlled. The gate structure may comprise two parts: a first gate electrode 132 arranged above at least a part of the source-side region 110 and coupled to the first channel portion 142, and a second gate electrode 144 coupled to the second channel portion 144 in the drain-side region 120. The first gate electrode 132 may be formed above the source-side well 142 as a metal layer structure that is separated from the well by a dielectric layer 152 acting as a gate oxide. The second gate electrode 134 may be formed in a trench or recess 124 arranged in the drain-side region 120. From a manufacturing process perspective, it may be desirable to let the trench follow a horizontal track along the substrate, and arrange the second gate electrode 134 as a rail, or buried rail, in the trench 124.

The trench 124 may in other words extend at least partly into the well 120, causing the second channel portion 144 and hence the current to take a longer path below the trench 124 on its way from the source 112 to the drain 122. The trench 124 may be configured to position the second gate electrode 134 between an edge of the first gate electrode 132 and the drain 122. Further, a second dielectric layer 154 may be provided between the well 120 and the second gate electrode 134, acting as a gate oxide. The second dielectric layer 154 may be thicker than the first dielectric layer 152 in order to withstand the electric field between the gate structure 132, 134 and prevent breakdown. Hence, the second gate electrode 134 may in the off-state increase the blocking voltage of the transistor. In the on-state, the second gate electrode 134 may be biased so as to reduce the resistance in the second channel portion 144 and thereby reduce power losses of the transistor.

Figure 2 shows a perspective view of a transistor device according to an embodiment. The transistor 100 may be similarly configured as the embodiment disclosed in connection with figure 1, with the difference that the present example is configured as a fin-FET. Thus, the transistor device according to figure 2 may comprise a source-side region 110 of a first conductivity type and a drain-side region 120 of a second conductivity type, wherein a source 112 is arranged in the source-side region 110 and a drain 122 is arranged in the drain-side region 120. Further, the transistor device 100 comprises a first gate electrode 132 arranged along and coupled to a first channel portion 142 in the source region, and a second gate electrode 134 arranged in a trench 124 in the drain-side region 120 and coupled to a second channel portion 144.

The above-described source- and drain side regions 110, 120 may be formed in two parallel semiconductor fins 10, 20 that extend beside each other in a horizontal direction along the substrate 160. The first and second fins 10, 20 may for example be formed by a fin patterning and fin cut process of the substrate, and may be at least partly embedded in an STI, such that only a portion of the first and second fin structure 10, 20 protrudes from the surface of the STI (not shown in figure 2).

A top portion of the first fin 10 may be divided into three different portions - a first portion 11, a second portion 12 and a third portion 13 - arranged after each other in the length direction of the fin, with the second portion 12 between, and sharing common boundaries with, the first and third portions 11, 13.

The source 112 may be arranged in the first portion 11, the source-side region 110 at least partly in the second portion 12, and the drain side region 120 at least partly in the third portion 13, such that a boundary between the source-side region 110 and the drain-side region 120 is arranged in the first fin 10. The drain-side region 120 may extend from the boundary, downwards through the first fin 10, into the underlying substrate 160 connecting the first and second fins 10, 20 and into the second fin 20, in which the drain 122 may be arranged. More specifically, the drain 122 may be arranged in a top portion of the second fin 20, at a length-wise location of the fin that corresponds to the length-wise location of the third portion 13 of the first fin 10. Put differently, the drain 122 may be arranged at a position abreast of, i.e., opposite to, the third portion 13 of the first fin 10.

This arrangement of the doped regions creates a current path that extends from the source 112, along the first fin 10 through the source-side region 110 and into the drain-side region 120, in which it continues downward into the substrate 160, below the trench 124 between the fins 10, 20 and up through the second fin 20 to the drain 122.

The flow of current along this path may be controlled by the gate structure, and more specifically by the first gate electrode 132 and the second gate electrode 134. The first gate electrode 132 may be arranged at the top portion of the first fin 10, and may couple to the first channel region 142 through a first dielectric layer 152 arranged between the first gate electrode 132 and the source-side region 110 and the drain-side region 120 of the first fin 10. The second gate electrode 134 may be arranged in the trench 124, such that it at least partly extends into the part of the drain-side region 120 arranged between the first and second fin 10, 20. A second dielectric layer 154 may be provided between the second gate electrode 134 and the drain-side region 120. The second gate electrode 134 may be provided in the form of a buried rail extending between the first and second fin 10, 20, and may further be connected to the first gate electrode 132 by means of an interconnect structure 136 providing a galvanic contact between the electrodes 132, 134.

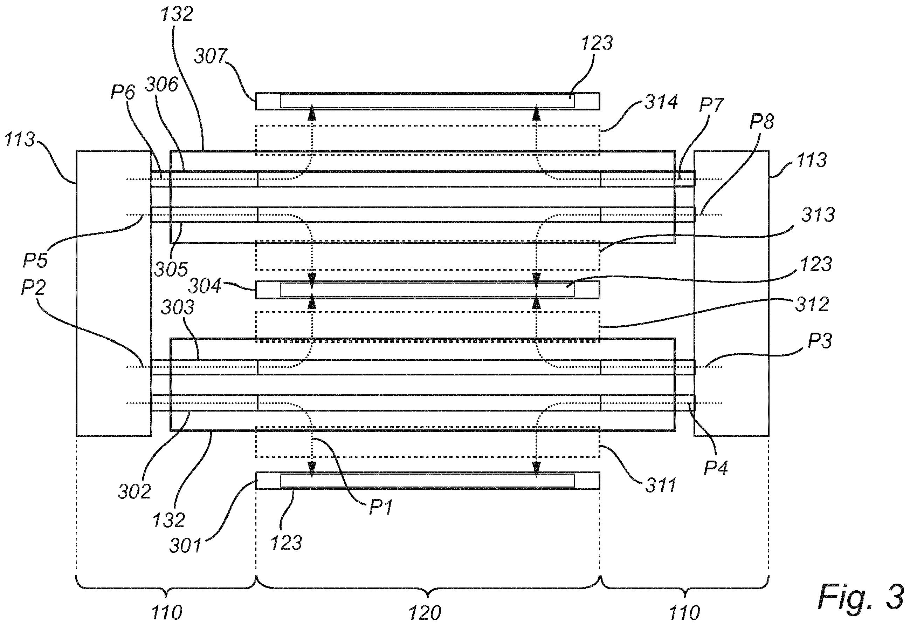

Figure 3 is a schematic outline of a layout comprising a plurality of fins and transistors similar to the embodiment disclosed in connection with figure 2. The layout may be based on a plurality of fin tracks arranged beside each other in a parallel and preferably equidistant pattern. The fin tracks indicate the position in which the semiconductor fins may be arranged. Figure 3 shows an example comprising 11 tracks, arranged in a consecutive order, wherein seven fins 301-307 are arranged in the first, third, fourth, sixth, eighth, ninth and eleventh track, respectively, and the remaining tracks, i.e. the second, fifth, seventh, and tenth track, are reserved for the trenches accommodating the second gate electrodes 311, 312, 313, 314. Thus, second gate electrodes may be arranged in trenches between fins 301 and 302, 303 and 304, 304 and 305, and 306 and 307, respectively.

Put differently, the present layout can be described as comprising two fin pairs 302, 303; 305, 306 arranged between each one of the remaining three fins 301, 304, 307, such that a first one 302, 303 of the fin pairs is arranged between a first one 301 and a second one 302 of the remaining fins, and the other one 305, 306 of the fin pairs is arranged between the second one 304 and a third one 307 of the remaining fins. Further, a second gate electrode 311, 312, 313, 314 is arranged between each fin pair 302, 303; 305, 306 and the remaining three fins 301, 304, 307 (buried in the trench; position indicated by dashed lines).

Source-side regions 110 may be arranged in the end portions of the fins of each fin pair 302, 303; 305, 306. The end portions may also comprise a source (not shown) connected by a source contact 113 that extends across the fin pairs 302, 303; 305, 306.

The drain-side regions 120 may be arranged in the middle part of the fins of the fin pairs 302, 303; 304, 307, between the drain-side regions 120. The drain-side region 120 may extend into the remaining three fins 301, 304, 307, which also may comprise a respective drain (not shown). Thus, the remaining three fins 301, 304, 307 may also be referred to as drain fins 301, 304, 307. Each one of the drain fins 301, 304, 307 may be contacted by a respective drain contact 123.

Each fin pair 302, 303; 305, 306 may be contacted by a respective first gate electrode 132 (outline indicated in figure 3), arranged between the source contacts 113. The first gate electrodes 132 may extend along the fins and over at least a part of the source-side region 110 and the drain-side region 120 of the fins. The first gate electrode 132 of each fin pair 302, 303; 305, 306 may be electrically connected to the neighbouring second gate electrodes 311, 312, 313, 314.

During operation, the fins of each fin pair 302, 303; 305, 306 may have a similar function as the first fin 10 in figure 2, whereas each of the drain fins 301, 304, 307 may have a similar function as the second fin 20 in the same figure. Thus, the first gate electrode 132 and the second gate electrodes 311, 312 may control a current flow (indicated by arrows P1-P4) from each of the source contacts 113, through fins 302 and 303 to the respective drain contacts 123 of fins 301 and 304.

The same applies to the first gate electrode 132 and the second gate electrodes 313, 314 arranged at the second fin par 305, 306, which may control a current flow (indicated by arrows P5-P8) from each of the source contacts 113, through fins 305, 306 to the respective drain contacts 123 of fins 304 and 307.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A field-effect transistor device (100) comprising:
a source-side region (110) of a first conductivity type and a source (112) of a second conductivity type formed in the source-side region;
a drain-side region (120) of the second conductivity type and a drain (122) of the second conductivity type formed in the drain-side region;
a gate structure (130) adapted to control a flow of current through a channel (140) between the source and the drain, the gate structure comprising:
a first gate electrode (132) arranged along and coupled to a first channel portion (142) in the source-side region; and
a second gate electrode (134) arranged in a trench (124) in the drain-side region and coupled to a second channel portion (144) in the drain-side region.

2. The field-effect transistor device according to claim 1, wherein:
the first gate electrode is coupled to the source-side region through a first dielectric layer (152); and
the second gate electrode is coupled to the drain-side region through a second dielectric layer (154), thicker than the first dielectric layer.

3. The field-effect transistor device according to claim 1 or 2, wherein the second gate electrode is arranged in a portion of the drain-side region separating the first gate electrode from the drain.

4. The field-effect transistor device according to any one of the preceding claims, wherein the first gate electrode and the second gate electrode are electrically connected to each other.

5. The field-effect transistor device according to any one of the preceding claims, wherein the second gate electrode is formed as a buried rail.

6. The field-effect transistor device according to any one of the preceding claims, wherein the source-side region shares a common boundary with the drain-side region.

7. The field-effect transistor device according to any one of the preceding claims, wherein the first channel portion abuts the second channel portion.

8. The field-effect transistor device according to any one of the preceding claims, further comprising:
a semiconductor substrate, wherein the source-side region and the drain-side region are arranged in a respective well in the substrate.

9. The field-effect transistor device according to any one of claims 1-7, comprising:
a semiconductor substrate (160);
first and second semiconductor fins (10, 20) extending in parallel horizontally along the substrate; wherein:
the trench extends horizontally alongside and between the first and second fins;
the source-side region is at least partly arranged in the first fin;
a boundary between the source-side region and the drain-side region is arranged in the first fin; and
the drain-side region extends from the boundary, below the trench and into the second fin.

10. The field-effect transistor device according to claim 9, wherein the source is arranged in a top portion of the first fin and the drain is arranged in a top portion of the second fin.

11. The field-effect transistor device according to claim 10, wherein:
the top portion of the first fin comprises a first portion (11), a second portion (12) and a third portion (13), all of which being arranged along each other in the length direction of the first fin; wherein:
the source is arranged in the first portion;
the source-side region is arranged in the second portion;
the drain-side portion is at least partly arranged in the third portion; and
the drain is arranged in the second fin, abreast of the third region of the first fin.

12. The field-effect transistor device according to claim 11, further comprising:
a source contact extending across the first region of the first fin; and
a drain contact extending along the second fin.
